# EUROPÄISCHE PATENTSCHRIFT

(11) **EP 4 200 913 B1**
(45) Veröffentlichungstag und Bekanntmachung des Hinweises auf die Patenterteilung: **16.09.2026**
(21) Anmeldenummer: 22798113.1
(22) Anmeldetag: 30.09.2022
(51) Int. Cl.: H10F 19/80, H10F 71/00

(54) **VERFAHREN UND VORRICHTUNG ZUM VERARBEITEN EINES SOLARMODULS**
METHOD AND DEVICE FOR PROCESSING A SOLAR MODULE
PROCÉDÉ ET DISPOSITIF DE TRAITEMENT D'UN MODULE SOLAIRE

(30) Priorität: 10.11.2021 DE 102021129301
(43) Veröffentlichungstag der Anmeldung: 28.06.2023
(73) Patentinhaber: Solar Materials GmbH, 39126 Magdeburg (DE)
(72) Erfinder: BARGEL, Jan, 39114 Magdeburg (DE); FRANKE, Fridolin, 39114 Magdeburg (DE); MAI, Jan-Philipp, 39114 Magdeburg (DE)
(74) Vertreter: Gramm, Lins & Partner Patent- und Rechtsanwälte PartGmbB
(86) Internationale Anmeldenummer: PCT/EP2022/077338
(87) Internationale Veröffentlichungsnummer: WO 2023/083528

(56) Entgegenhaltungen:
- WO-A1-2021/149545
- JP-A- 2011 173 099
- JP-A- 2018 140 353
- US-A1- 2005 000 560
- US-A1- 2008 105 294

## Beschreibung

Die Erfindung betrifft ein Verfahren zum Verarbeiten eines Solarmoduls, wobei das Solarmodul wenigstens einen Silizium-Grundkörper mit einer ladungsdotierten Zone, einer lochdotierten Zone und einer Oberseite, metallische Leiterbahnen an der Oberseite des Grundkörpers, eine für sichtbares Licht zumindest teiltransparente, vorzugsweise für sichtbares Licht transparente, Deckschicht und wenigstens eine Haftschicht aufweist, die zwischen der Deckschicht und den Leiterbahnen angeordnet ist. Die Erfindung betrifft zudem eine Vorrichtung zum Durchführen eines solchen Verfahrens.

Solarmodule der oben genannten Art werden in wachsender Zahl verwendet, um aus Sonnenlicht elektrischen Strom zu erzeugen. Diese Solarmodule können beispielsweise in kleiner Zahl auf privaten Dächern beispielsweise auf Wohngebäuden platziert werden, um den Strombedarf des Hauses, auf dem die Solarmodule montiert sind, zumindest teilweise zu decken. Eine derartige dezentrale Energieversorgung wird in steigender Anzahl genutzt, auch um beispielsweise Elektro-Fahrzeuge dezentral laden zu können. Solarmodule der oben genannten Art werden jedoch auch in großen Anlagen auf ansonsten landwirtschaftlich genutzten Flächen genutzt um gewerblich elektrischen Strom zu erzeugen und diesen in das öffentliche Stromnetz einzuspeisen.

Nachteilig ist, dass die Solarmodule nur eine begrenzte Lebensdauer aufweisen. Bei der Herstellung der Solarmodule werden teure Rohstoffe verwendet. Die Leiterbahnen werden beispielsweise bei einer großen Anzahl von Modulen aus Silber hergestellt. Allein aus diesem Grund gibt es einen Bedarf für ein Verfahren, mit dem diese Rohstoffe recycelt und der Wiederverwertung zugänglich gemacht werden. Doch die steigende Zahl der Solarmodule, die die Lebensdauer erreichen und aussortiert werden, sorgt zudem für eine große Menge Abfall, der gerade vor dem Hintergrund der Umweltverträglichkeit der Stromerzeugung, für die Solarmodule und die Erzeugung von Strom aus Sonnenlicht stehen, recycelt oder zumindest aufbereitet werden sollte. Für Solarmodule, bei denen Metallkomponenten auf einem Glassubstrat angeordnet sind, wird in der JP 2014/054593 A ein Verfahren vorgeschlagen, bei dem die Komponenten mechanisch entfernt werden. Das dort beschriebene Glas ist der mechanischen Beanspruchung gewachsen, weshalb genau diese Substrate dort beschrieben und offenbart werden. Für andere Substrate sind bisher aus dem Stand der Technik nur Verfahren bekannt, bei denen nasschemische Verfahren zur Anwendung kommen, die aufgrund der hohen Kosten, der oftmals umwelt- und/oder gesundheitsschädlichen verwendeten Stoffe und dem hohen Aufwand nachteilig sind.

JP 2011/173099 A beschreibt einen Zerkleinerungsschritt des Solarzellensubstrats, gefolgt von einem Trennschritt zur Gewinnung der Elektroden.

Der Erfindung liegt daher die Aufgabe zugrunde, ein Verfahren vorzuschlagen, mit dem die Nachteile aus dem Stand der Technik behoben oder zumindest gemildert werden können.

Die Erfindung löst die gestellte Aufgabe durch ein Verfahren der oben beschriebenen Art, dass die folgenden Schritte aufweist:
a) Erwärmen der wenigstens einen Haftschicht,
b) Entfernen der Deckschicht von dem Grundkörper und
c) Mechanisches Abtragen der Leiterbahnen und Auffangen des abgetragenen Materials.

Eine Schwierigkeit, die durch das erfindungsgemäße Verfahren behoben wird, besteht darin, dass die Leiterbahnen der Solarmodule, die aus dem wertvollen Rohstoff hergestellt sind, nicht von außen zugänglich sind. Sie befinden sich zwar auf der Oberseite des Grundkörpers, sind jedoch durch die Deckschicht abgedeckt, die durch die wenigstens eine Haftschicht befestigt ist. Indem die Haftschicht erwärmt wird, verringert sich deren Haftwirkung, sodass danach die Deckschicht und der Grundkörper voneinander entfernt werden können. Danach sind die an der Oberseite des Grundkörpers angeordneten Leiterbahnen zugänglich. Sie werden nun durch mechanisches Abtragen vom Grundkörper entfernt und dazu abgetragene Material aufgefangen.

Vorzugsweise wird die Haftschicht mittels Infrarot-Strahlung und/oder magnetischer Induktion und/oder mittels Mikrowellenstrahlung erwärmt. Die Erwärmung findet statt auf eine Temperatur von mehr als 180 °C, vorzugsweise mehr als 200 °C, besonders bevorzugt mehr als 230 °C und weniger als 400 °C, bevorzugt weniger als 350 °C, besonders bevorzugt weniger als 280 °C. Insbesondere bei der Verwendung von Infrarot-Strahlung oder Mikrowellenstrahlung ist es von Vorteil, die Strahlung durch die Deckschicht, die vorzugsweise für die jeweilige Art von Strahlung zumindest teilweise, vorzugsweise jedoch vollständig transparent ist, aufzubringen. Infrarotstrahlung, die dazu verwendet wird, hat vorzugsweise eine Wellenlänge von 1000 bis 4000 nm, bevorzugt von 1000 bis 2000 nm. Die bevorzugte Temperatur liegt unterhalb von 400 °C. Oberhalb dieser Temperatur tritt die Pyrolyse ein, bei der zum Teil giftige und umweltschädliche Gase frei werden. Mit einer Temperatur unterhalb von 400 °C kann dies vermieden werden. Bei einer Temperatur von mehr als 180 °C, bevorzugt mehr als 200 °C wird vorzugsweise in der Haftschicht Essigsäure freigesetzt, die einen Schmierfilm zwischen den durch die Haftschicht verbundenen Schichten, also vorzugsweise dem Grundkörper und der Deckschicht, entstehen lässt. Dadurch nehmen die Adhäsionskräfte, die durch die Haftschicht aufgebracht werden, ab und die beiden miteinander verbundenen Elemente können voneinander getrennt werden. Vorzugsweise wird als Haftschicht zumindest auch eine Folie aus Ethylen-Vinylacetat (EVA) verwendet, die bei Erwärmung in dem genannten Temperaturbereich Essigsäure freigibt.

Nachdem die Haftschicht auf die gewünschte Temperatur erwärmt wurde, kann entweder eine Wärmequelle abgeschaltet werden oder so gesteuert werden, dass die Temperatur für eine gewisse Zeitdauer, beispielsweise 10 Minuten, konstant gehalten wird, um das Solarmodul bei dieser Temperatur der Haftschicht zu bearbeiten. Die Erwärmung erfolgt vorzugsweise vollflächig, sodass die gesamte Haftschicht des zu bearbeitenden Solarmoduls gleichmäßig erwärmt wird. Alternativ dazu ist es auch möglich, einen Teil der Haftschicht zu erwärmen und beispielsweise die Wärmequelle relativ zum Solarmodul oder umgekehrt zu bewegen. Das Solarmodul befindet sich beim Erwärmen vorzugsweise in einem Vakuum, wird also einem Unterdruck ausgesetzt. Auch die Erwärmung unter normalem Druck ist jedoch möglich.

Wird als Wärmequelle eine elektromagnetische Strahlung verwendet, kann diese durch die für diese Strahlung zumindest teilweise transparente Deckschicht direkt in die zu erwärmende Haftschicht eingebracht werden. Dies ist bei der Verwendung von magnetischer Induktion als Wärmequelle anders, da die Haftschicht in der Regel nicht magnetisch oder magnetisierbar ist. **In** diesem Fall wird durch das magnetischer Induktionsfeld eine andere Schicht des Solarmoduls, vorzugsweise der Grundkörper, der auch Substrat oder Wafer genannt werden kann, erwärmt, sodass er dann Wärme an die auf ihm angeordnete Haftschicht abgibt.

Auch Laser können zusätzlich oder alternativ zu den genannten Wärmequellen verwendet werden, um die wenigstens eine Haftschicht zu erwärmen.

**In** einer bevorzugten Ausgestaltung wird die Deckschicht von dem Grundkörper entfernt, indem entgegengesetzte wirkende Kräfte, vorzugsweise entgegengesetzt wirkende Zugkräfte auf die Deckschicht und den Grundkörper aufgebracht werden. Die entgegengesetzt wirkenden Zugkräfte können dabei senkrecht zur Oberseite des Grundkörpers aufgebracht werden. Bei einem auf einer Arbeitsplatte liegenden Solarmodul bedeutet dies, dass die Zugkräfte nach oben und unten wirken. Dazu werden bevorzugt Unterdruckelemente, beispielsweise Saugelemente verwendet. Das Substrat wird dazu bevorzugt auf einer Arbeitsfläche positionier, die Öffnungen aufweist, die dann von dem Substrat verschlossen werden. Durch Anlegen eines Unterdruckes oder einer Saugkraft an die verschlossenen Öffnungen wird eine Saugkraft und damit eine Zugkraft auf das Substrat ausgeübt, die es an der Arbeitsfläche hält. An die Deckschicht wird bevorzugt wenigstens Saugelement oder wenigstens ein Sauggreifer angeordnet, der eingerichtet ist, eine Saugkraft auf die Deckschicht aufzubringen, die von der Arbeitsfläche weg gerichtet ist, in der Regel also nach oben wirkt. Dadurch werden zwei entgegen gerichtete Kräfte aufgebracht und die Deckschicht von dem Substrat getrennt.

Alternativ oder zusätzlich wird durch wenigstens einen Schieber eine parallel zu der Arbeitsfläche, an der das Substrat angeordnet ist, wirkende Kraft auf die Deckschicht aufgebracht. Das Substrat wird bevorzugt durch die bereits beschriebene Saugkraft an der Arbeitsfläche festgehalten. Alternativ oder zusätzlich dazu verfügt die Arbeitsfläche über einen Anschlag, der von der Arbeitsfläche hervorsteht und an dem das Substrat anliegt. Das Substrat liegt dabei so an dem Anschlag an, dass eine Bewegung des Substrates, die durch die von dem Schieber aufgebrachte Kraft hervorgerufen würde, unterbunden wird und nicht möglich ist. Bringt der Schieber eine Kraft auf eine erste Seitenfläche der Deckschicht auf, liegt das Substrat bevorzugt mit der gegenüberliegenden Seitenfläche an dem Vorsprung an.

Alternativ dazu können die entgegengesetzt wirkenden Zugkräfte auch parallel zur Oberseite des Grundkörpers aufgebracht werden. Dann kommt es zu Scherkräften, durch die die beiden Bauteile voneinander getrennt werden.

In einer bevorzugten Ausgestaltung wird die Deckschicht vor dem Erwärmen der Haftschicht oder vor dem Entfernen der Deckschicht von dem Grundkörper beschädigt oder zerstört. Dabei wird die Deckschicht vorzugsweise durch mechanische Beanspruchung in mehrere Teile aufgeteilt. Dies kann beispielsweise geschehen, indem auf die Deckschicht beispielsweise mit einem Hammer, geschlagen wird. Die Deckschicht liegt dann in mehreren Einzelteilen vor, von denen die meisten, vorzugsweise alle, noch immer über die Haftschicht mit dem Grundkörper verbunden sind. Diese Einzelteile können dann auf die bereits beschriebenen Weisen von dem Grundkörper entfernt werden.

Wenn die Deckschicht und der Grundkörper derart voneinander getrennt werden, dass sie dabei parallel bewegt werden, werden insbesondere auf den Grundkörper, auf dessen Oberseite sich die Leiterbahnen befinden, wenig Biegemomente aufgebracht, sodass die Gefahr reduziert wird, dass der Grundkörper bricht. Dieses von Vorteil, davon dem Grundkörper die Leiterbahnen mechanisch abgetragen werden, was umso einfacher ist, je weniger mechanisch beschädigt der Grundkörper ist.

Vorzugsweise wird vor dem Entfernen der Deckschicht die Deckschicht mittels eines Werkzeugs, vorzugsweise eines Spatels, Spachtels, Messers oder Drahtes, beschädigt, wobei das Werkzeug vorzugsweise zwischen die Deckschicht und den Grundkörper eingeführt wird. Anders als beim Grundkörper, der nach dem Entfernen von der Deckschicht vorzugsweise unbeschädigt ist und keine Brüche aufweist, wird die Deckschicht durchaus beschädigt, um einzelne Teile Deckschicht leichter entfernen zu können.

Vorzugsweise wird beim Entfernen der Deckschicht auch die wenigstens eine Haftschicht zumindest teilweise, vorzugsweise jedoch vollständig, entfernt. Dadurch wird erreicht, dass möglichst wenige Anteile der Haftschicht auf der Oberseite des Grundkörpers und damit auf den Leiterbahnen verbleiben. Diese Anteile würden beim mechanischen Abtragen der Leiterbahnen mit abgetragen mit dem abgetragene Material aufgefangen. Sie müssten dann gegebenenfalls aufwendig und kostenintensiv vom Material der Leiterbahnen getrennt werden.

Vorzugsweise wird daher die Haftschicht nach dem Entfernen der Deckschicht wenigstens teilweise, bevorzugt jedoch vollständig, entfernt. Dabei kann es von Vorteil sein, die verbleibenden Anteile der Haftschicht erneut zu erwärmen, sofern die Haftschicht nicht mehr eine ausreichende Wärme aufweist.

Besonders bevorzugt wird zum Entfernen der wenigstens einen Haftschicht nach dem Entfernen der Deckschicht ein mechanisches Werkzeug verwendet, beispielsweise ein Draht, ein Spatel, ein Spachtel, eine Klinge, ein Messer oder eine Bürste.

Vorzugsweise erfolgt das Abtragen der Leiterbahnen durch Bürsten, Fräsen, Hobeln, Stoßen, Schaben, Meißeln, Räumen, Strahlspanen und/oder Schleifen. Das Abtragen kann mittels geometrisch bestimmter oder geometrisch unbestimmter Schneide erfolgen. Das abzutragen Material kann auch durch Spannbürsten entfernt werden, wobei beispielsweise Rundbürsten, Tellerbürsten, Pinselbürsten, Walzenbürsten, Handbürsten und/oder Leistenbürsten verwendet werden können. Die Bürsten können aus Eisen, Kunststoff, Messing oder einem anderen Material oder Materialgemisch hergestellt sein. Der Borstendurchmesser und Borstenlänge kann variieren. Die Bürste kann rotieren, oszillieren, linear oder exzentrisch bewegt werden. In einer bevorzugten Ausgestaltung wird eine rotierende Walzenbürste mit Stahldraht verwendet, die mit 2000-8000 Umdrehungen pro Minute rotiert.

Die Bürste kann Vollflächig oder Abschnittsweise arbeiten und Kraftgesteuert und/oder weggesteuert sein.

Beim Fräsen wird vorzugsweise ein Stirnfräser eingesetzt, bei dem die Werkzeugachse orthogonal zur Oberfläche ist, die abgetragen werden soll. Bei anderen Werkzeugen, wie Klingen oder Messern werden bevorzugt Werkzeuge oder Klingen aus Stahl, kubisch kristallinem Bornitrid (CBN), Aluminiumoxid-Keramik, polykristallinem Diamant (PKD), Siliziumnitrid-Keramik, Schnellarbeitsstahl (HSS) verwendet. Als Werkstoffe für diese Werkzeuge können auch beschichtete Hartmetalle, Hartmetalle auf Wolframcarbid-Basis oder Feinkorn Hartmetalle verwendet werden. Die Klinge kann in unterschiedlichen Winkeln zu den Leiterbahnen ausgerichtet werden, wobei ein 45° Winkel von Vorteil ist. Die Anstellung des Messers kann variieren, je nach Schliff der Klinge. Die Klinge kann Oszillieren und oder Linear verfahren und z.B. Kraft- und oder Weggesteuert sein. Das Abtragen kann vollflächig oder Abschnittsweise erfolgen. Es wird mindestens eine Klinge verwendet.

Beim Schleifen mit rotierendem Werkzeug wird vorzugsweise das Pendelschleifen eingesetzt. Die Schleifscheibe ist vorzugsweise eine CBN-Scheibe oder eine Diamantschleifscheibe. Wird das Bandschleifen verwendet, so wird das Band vorzugsweise parallel zur Oberfläche, die abgetragen werden soll, ausgerichtet. Die Bandkante kann ebenfalls parallel zu den Leiterbahnen ausgerichtet werden. Es kann vollflächig oder abschnittsweise abgetragen werden.

Das abgetragene Material wird aufgefangen. Dabei wird es vorzugsweise abgesaugt und in einem Behälter aufgefangen. Dazu ist es von Vorteil, wenn sich das Werkzeug, das zum Abtragen verwendet wird, bereits innerhalb eines Kastens oder einer Glocke befindet, damit der abgetragene Staub möglichst leicht aufgefangen werden kann. Das Material kann mit einem Luftstrom oder einem Flüssigkeitsstrom, beispielsweise aus Wasser oder einem Öl, aufgefangen werden. Vorzugsweise wird jedoch keine Flüssigkeit verwendet, da die abgetragenen Späne oder Stäube später getrocknet werden müssen.

Die Erfindung löst die gestellte Aufgabe durch eine Vorrichtung zum Durchführen eines hier beschriebenen Verfahrens, die wenigstens eine Heizeinrichtung zum Erwärmen der wenigstens einen Haftschicht, wenigstens eine Zugeinrichtung zum Ausüben einer Zugkraft, eine mechanische Abtrageinrichtung und eine Auffangeinrichtung aufweist. Vorzugsweise verfügt die Zugeinrichtung über wenigstens einen, bevorzugt mehrere Vakuumgreifer und/oder wenigstens einen, bevorzugt jedoch mehrere Bernoulli-Greifer.

In einer bevorzugten Ausgestaltung verfügt die Vorrichtung zudem über eine elektrische Steuerung und die Abtrageinrichtung über wenigstens ein mechanisches Werkzeug, bei die elektrische Steuerung eingerichtet ist, wenigstens einen Betriebsparameter des wenigstens einen mechanischen Werkzeuges zu steuern. Der wenigstens eine Betriebsparameter ist vorzugsweise ein Anpressdruck, ein Weg oder eine Kraft. Die elektrische Steuerung ist vorzugsweise eine elektronische Datenverarbeitungseinrichtung, die vorzugsweise Teil der Vorrichtung ist. Es ist jedoch auch ausreichend, wenn die elektronische Datenverarbeitungseinrichtung nicht Teil der Vorrichtung ist, sondern die Vorrichtung über eine Kommunikationseinrichtung mit der elektronischen Datenverarbeitungseinrichtung kommuniziert.

Mithilfe der beiliegenden Figuren wird nachfolgend ein Ausführungsbeispiel der vorliegenden Erfindung näher erläutert. Es zeigen:

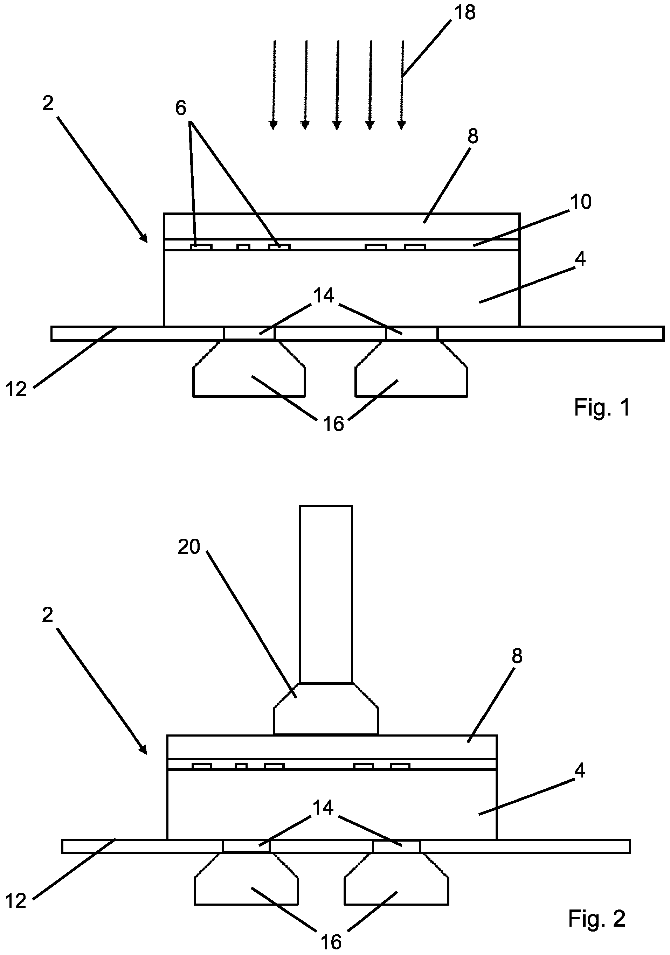

Figuren 1 bis 4 - Verfahrensschritte eines Verfahrens gemäß einem ersten Ausführungsbeispiel der vorliegenden Erfindung.

Figur 1 zeigt ein Solarmodul 2, dass ein Substrat 4 aufweist, auf dem Leiterbahnen 6 angeordnet sind. Die Leiterbahnen 6 werden von einer Deckschicht 8 abgedeckt, die an dem Substrat 4 über eine Haftschicht 10 befestigt ist, die die Leiterbahnen 6 umgibt. Das Solarmodul 2 befindet sich auf einer Arbeitsfläche 12, die im gezeigten Ausführungsbeispiel zwei Öffnungen 14 aufweist, die von dem darauf angeordneten Substrat 4 verschlossen werden. Unterhalb der Öffnungen 14 ist jeweils eine Saugeinrichtung 16 angeordnet, die nur schematisch dargestellt sind. Die Saugeinrichtung 16 sind eingerichtet, die Öffnungen 14 mit einem Unterdruck zu beaufschlagen und so eine Saugkraft auf das Substrat 4 des Solarmoduls 2 auszuüben. Im Verfahrensschritt gemäß Figur 1 wird das Solarmodul 2 von oben mittels elektromagnetischer Strahlung 18, die beispielsweise von einem Laser hervorgerufen werden kann, erwärmt. Da die Deckschicht 8 für sichtbares Licht zumindest teiltransparent, vorzugsweise jedoch vollständig transparent ist, tritt die elektromagnetische Strahlung 18 durch die Deckschicht 8 hindurch und erwärmt die Haftschicht 10.

Figur 2 zeigt einen späteren Verfahrensschritt. Das Solarmodul 2 befindet sich noch immer auf der Arbeitsfläche 12. Das Substrat 4 wird noch immer durch die Saugeinrichtungen 16 an der Arbeitsfläche 12 festgehalten. An der Deckschicht 8 greift in diesem Verfahrensschritt ein Sauggreifer 20 an, der auf die Deckschicht 8 eine nach oben wirkende Kraft ausübt. Zwischen dem Substrat 4 und der Deckschicht 8 wirken somit 2 entgegengesetzte Kräfte, wodurch die Deckschicht 8 von dem Substrat 4 entfernt wird.

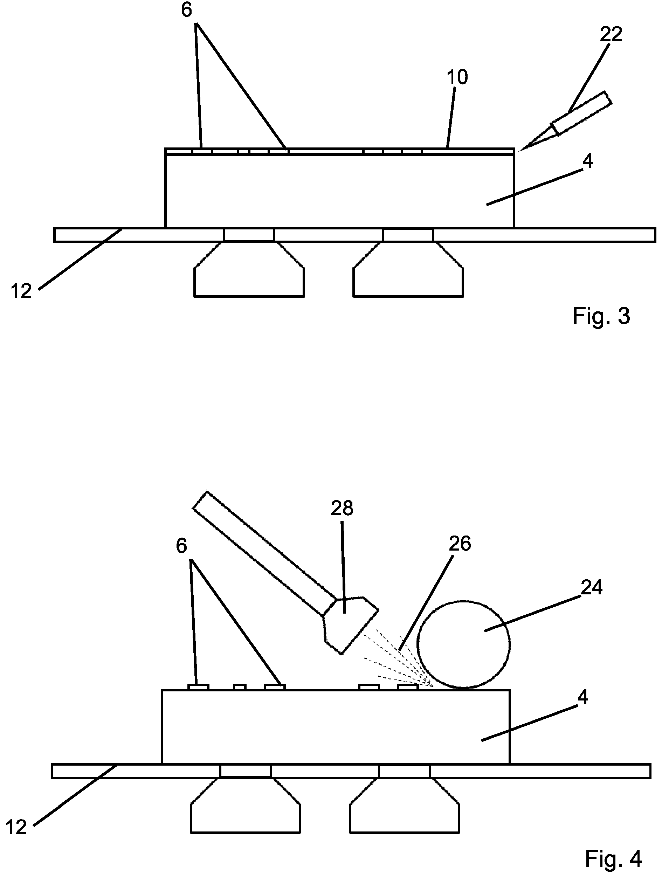

Figur 3 zeigt die Situation im nächsten Arbeitsschritt. Das Substrat 4 wird weiterhin an der Arbeitsfläche 12 festgehalten und an der der Arbeitsfläche 12 abgewandten Seite des Substrates 4 befinden sich die Leiterbahnen 6. Diese sind nach dem Entfernen der Deckschicht 8 vom Substrat 4 noch immer zumindest teilweise von der Haftschicht 10 umgeben. Dies ist in Figur 3 dadurch illustriert, dass die Haftschicht 10 im Vergleich zur Haftschicht 10 in den Figuren 1 und 2 deutlich dünner ausgebildet ist. Dabei handelt es sich nicht um eine realistische Darstellung. Beim Entfernen der Deckschicht 8 vom Substrat 4 wird ein Teil der Haftschicht 10 mit entfernt. Dies geschieht jedoch je nach Erwärmungszustand und Hafteigenschaften unregelmäßig und keineswegs homogen. Es kann durchaus Bereiche geben, in denen die Haftschicht 10 vollständig entfernt wurde. Es kann durchaus Bereiche geben, in denen die Leiterbahnen 6 noch vollständig von der Haftschicht 10 umgeben sind. Der verbleibende Teil der Haftschicht 10, der in Figur 3 dargestellt ist, wird in diesem Verfahrensschritt durch ein Werkzeug 22, das beispielsweise ein Spatel oder ein Messer sein kann, entfernt.

In Figur 4 ist die Haftschicht 10 vollständig von der Oberseite des Substrates 4 entfernt worden. Dabei sind die Leiterbahnen 6 noch an der Oberfläche des Substrates 4 angeordnet. Auch dabei handelt es sich um eine schematische und nicht um eine realistische Darstellung. Auch in diesem Verfahrensschritt werden Reste der Haftschicht 10 an der Oberfläche des Substrates 4 verbleiben. Durch eine Bürste 24, die im gezeigten Ausführungsbeispiel in Rotation im Uhrzeigersinn versetzt ist und die sich relativ zur Oberfläche des Substrates 4 bewegt, werden die Leiterbahnen 6 vom Substrat 4 entfernt. Dabei wird Material 26 emporgeschleudert und anschließend von einem Sauger 28 aufgefangen und der weiteren Verarbeitung zugeführt.

### Bezugszeichenliste

2 Solarmodul
4 Substrat
6 Leiterbahn
8 Deckschicht
10 Haftschicht
12 Arbeitsfläche
14 Öffnung
16 Saugeinrichtung
18 elektromagnetische Strahlung
20 Sauggreifer
22 Werkzeug
24 Bürste
26 Material
28 Sauger

## Patentansprüche

1. Verfahren zum Verarbeiten eines Solarmoduls, wobei das Solarmodul
- wenigstens einen Silizium-Grundkörper mit einer ladungsdotierten Zone, einer lochdotierten Zone und einer Oberseite,
- metallische Leiterbahnen an der Oberseite des Grundkörpers,
- eine für sichtbares Licht zumindest teiltransparente, vorzugsweise für sichtbares Licht transparente, Deckschicht und
- wenigstens eine Haftschicht aufweist, die zwischen der Deckschicht und den Leiterbahnen angeordnet ist,
aufweist, wobei das Verfahren folgende Schritte aufweist:
a) Erwärmen der wenigstens einen Haftschicht,
b) Entfernen der Deckschicht von dem Grundkörper und
c) Mechanisches Abtragen der Leiterbahnen von dem Grundkörper und Auffangen des abgetragenen Materials.

2. Verfahren nach Anspruch 1, **dadurch gekennzeichnet, dass** die Haftschicht mittels Infrarot-Strahlung und/oder magnetischer Induktion und/oder Mikrowellenstrahlung auf eine Temperatur von mehr als 180 °C, vorzugsweise von mehr als 200 °C, besonders bevorzugt mehr als 230 °C und weniger als 400 °C, vorzugsweise weniger als 350 °C, besonders bevorzugt weniger als 280 °C erwärmt wird.

3. Verfahren nach Anspruch 1 oder 2, **dadurch gekennzeichnet, dass** die Deckschicht von dem Grundkörper entfernt wird, indem entgegengesetzt wirkende Kräfte, vorzugsweise entgegengesetzt wirkende Zugkräfte auf die Deckschicht und den Grundkörper aufgebracht werden.

4. Verfahren nach einem der vorstehenden Ansprüche, **dadurch gekennzeichnet, dass** vor dem Entfernen der Deckschicht die Deckschicht mittels eines Werkzeugs, vorzugsweise ein Spatel, Spachtel, Messer oder Draht, beschädigt wird, wobei das Werkzeug vorzugsweise zwischen die Deckschicht und den Grundkörper eingeführt wird.

5. Verfahren nach einem der vorstehenden Ansprüche, **dadurch gekennzeichnet, dass** beim Entfernen der Deckschicht auch die wenigstens Haftschicht zumindest teilweise, vorzugsweise vollständig, entfernt wird.

6. Verfahren nach Anspruch 5, **dadurch gekennzeichnet, dass** wenigstens Haftschicht nach dem Entfernen der Deckschicht wenigstens teilweise, vorzugswiese vollständig, entfernt wird.

7. Verfahren nach Anspruch 6, **dadurch gekennzeichnet, dass** zum Entfernen der wenigstens einen Haftschicht nach dem Entfernen der Deckschicht ein mechanisches Werkzeug verwendet wird, das vorzugsweise ein Draht, Spatel, Spachtel, eine Klinge oder ein Messer aufweist oder ist.

8. Verfahren nach einem der vorstehenden Ansprüche, **dadurch gekennzeichnet, dass** das Abtragen der Leiterbahnen durch Bürsten, Fräsen, Hobeln, Stoßen, Schaben, Meißeln, Räumen, Strahlspanen und/oder Schleifen geschieht.

9. Verfahren nach einem der vorstehenden Ansprüche, **dadurch gekennzeichnet, dass** das abgetragene Material abgesaugt und in einem Behälter aufgefangen wird.

10. Vorrichtung zum Durchführen eines Verfahrens nach einem der vorstehenden Ansprüche, **dadurch gekennzeichnet, dass** die Vorrichtung eine Heizeinrichtung zum Erwärmen der wenigstens einen Haftschicht, wenigstens eine Zugeinrichtung zum Ausüben der Zugkraft, eine mechanische Abtrageinrichtung und eine Auffangeinrichtung aufweist.

11. Vorrichtung nach Anspruch 10, **dadurch gekennzeichnet, dass** die Zugeinrichtung wenigstens einen, vorzugsweise mehrere Vakuumgreifer aufweist.

12. Vorrichtung nach Anspruch 10 oder 11, **dadurch gekennzeichnet, dass** die Vorrichtung eine elektrische Steuerung und die Abtrageinrichtung wenigstens ein mechanisches Werkzeug aufweist, wobei die elektrische Steuerung eingerichtet ist, wenigstens einen Betriebsparameter des wenigstens einen mechanischen Werkzeuges zu steuern.

13. Vorrichtung nach Anspruch 12, **dadurch gekennzeichnet, dass** der wenigstens eine Betriebsparameter ein Anpressdruck, ein Weg oder eine Kraft ist.

## Claims

1. A method for processing a solar module, the solar module comprising
- at least one silicon base body with a charge-doped zone, a hole-doped zone and an upper side,
- metallic conductor tracks on the upper side of the base body,
- a cover layer that is at least partially transparent to visible light, preferably transparent to visible light, and
- at least one adhesive layer arranged between the cover layer and the conductor tracks,
the method comprising the following steps:
a) heating the at least one adhesive layer,
b) removing the cover layer from the base body and
c) mechanically removing the conductor tracks from the base body and collecting the removed material.

2. The method according to claim 1, **characterized in that** the adhesive layer is heated by means of infrared radiation and/or magnetic induction and/or microwave radiation to a temperature of more than 180 °C, preferably more than 200 °C, especially preferably more than 230 °C and less than 400 °C, preferably less than 350 °C, especially preferably less than 280 °C.

3. The method according to claim 1 or 2, **characterized in that** the cover layer is removed from the base body by applying forces acting in the opposite direction, for example applying tensile forces acting in the opposite direction, to the cover layer and the base body.

4. The method according to one of the preceding claims, **characterized in that**, prior to removing the cover layer, the cover layer is damaged by means of a tool, preferably a spatula, scraper, knife or wire, the tool preferably being inserted between the cover layer and the base body.

5. The method according to one of the preceding claims, **characterized in that** the at least one adhesive layer is also at least partially, preferably completely, removed when the cover layer is removed.

6. The method according to claim 5, **characterized in that** the at least one adhesive layer is at least partially, preferably completely, removed after the cover layer has been removed.

7. The method according to claim 6, **characterized in that** a mechanical tool, which preferably has or is a wire, spatula, scraper, blade, knife or brush, is used for removing the at least one adhesive layer after removing the cover layer.

8. The method according to one of the preceding claims, **characterized in that** the conductor tracks are removed by brushing, milling, planing, shaping, scraping, chiseling, broaching, blasting and/or grinding.

9. The method according to one of the preceding claims, **characterised in that** machined material is sucked up and collected in a container.

10. A device for carrying out a method according to one of the preceding claims, **characterized in that** the device comprises at least one heating device for heating the at least one adhesive layer, at least one traction device for exerting a tensile force, a mechanical removal device and a collection device.

11. The device according to claim 10, **characterized in that** the traction device comprises at least one, preferably multiple, vacuum grippers.

12. The device according to claim 10 or 11, **characterized in that** the device comprises an electric control unit and the removal device has at least one mechanical tool, wherein the electric control unit is configured to control at least one operating parameter of the at least one mechanical tool.

13. The device according to claim 12, **characterised in that** the at least one operating parameter is a contact pressure, a path or a force.

## Revendications

1. Procédé de traitement d'un module solaire, ledit module solaire comportant
- au moins un corps de base en silicium présentant une zone dopée en charges, une zone dopée en trous et une face supérieure,
- des pistes conductrices métalliques sur la face supérieure du corps de base,
- une couche de recouvrement au moins partiellement transparente à la lumière visible, de préférence transparente à la lumière visible, et
- au moins une couche adhésive disposée entre la couche de recouvrement et les pistes conductrices,
le procédé comprenant les étapes suivantes consistant à :
a) chauffer ladite au moins une couche adhésive,
b) retirer la couche de recouvrement du corps de base, et
c) enlever mécaniquement les pistes conductrices du corps de base et récupérer le matériau enlevé.

2. Procédé selon la revendication 1,
**caractérisé en ce que** la couche adhésive est chauffée à une température supérieure à 180 °C, de préférence supérieure à 200 °C, de manière particulièrement préférée supérieure à 230 °C, et inférieure à 400 °C, de préférence inférieure à 350 °C, et de manière particulièrement préférée inférieure à 280 °C, au moyen d'un rayonnement infrarouge et/ou d'une induction magnétique et/ou d'un rayonnement micro-ondes.

3. Procédé selon la revendication 1 ou 2,
**caractérisé en ce que** la couche de recouvrement est retirée du corps de base en appliquant des forces agissant en sens opposés, de préférence des forces de traction agissant en sens opposés, sur la couche de recouvrement et le corps de base.

4. Procédé selon l'une des revendications précédentes,
**caractérisé en ce qu'**avant le retrait de la couche de recouvrement, la couche de recouvrement est endommagée à l'aide d'un outil, de préférence une spatule, une truelle, un couteau ou un fil métallique, l'outil étant de préférence introduit entre la couche de recouvrement et le corps de base.

5. Procédé selon l'une des revendications précédentes,
**caractérisé en ce que**, lors du retrait de la couche de recouvrement, ladite au moins une couche adhésive est également retirée au moins partiellement, de préférence entièrement.

6. Procédé selon la revendication 5,
**caractérisé en ce que** ladite au moins une couche adhésive est retirée au moins partiellement, de préférence entièrement, après le retrait de la couche de recouvrement.

7. Procédé selon la revendication 6,
**caractérisé en ce que**, pour retirer ladite au moins une couche adhésive après le retrait de la couche de recouvrement, on utilise un outil mécanique qui, de préférence, comprend ou est lui-même un fil métallique, une spatule, une truelle, une lame ou un couteau.

8. Procédé selon l'une des revendications précédentes,
**caractérisé en ce que** l'enlèvement des pistes conductrices s'effectue par brossage, fraisage, rabotage, à l'étau limeur, par raclage, ciselage, brochage, grenaillage et/ou par meulage.

9. Procédé selon l'une des revendications précédentes,
**caractérisé en ce que** le matériau enlevé est aspiré et récupéré dans un récipient.

10. Dispositif destiné à mettre en œuvre un procédé selon l'une des revendications précédentes,
**caractérisé en ce que** le dispositif comprend un moyen de chauffage destiné à chauffer ladite au moins une couche adhésive, au moins un moyen de traction destiné à exercer la force de traction, un moyen d'enlèvement mécanique et un moyen de récupération.

11. Dispositif selon la revendication 10,
**caractérisé en ce que** le moyen de traction comprend au moins une, de préférence plusieurs pinces à vide.

12. Dispositif selon la revendication 10 ou 11,
**caractérisé en ce que** le dispositif comprend une commande électrique et **en ce que** le moyen d'enlèvement comprend au moins un outil mécanique, la commande électrique étant agencée pour commander au moins un paramètre de fonctionnement dudit au moins un outil mécanique.

13. Dispositif selon la revendication 12,
**caractérisé en ce que** ledit au moins un paramètre de fonctionnement est une pression d'appui, une course ou une force.
